(19) Europäisches Patentamt / European Patent Office / Office européen des brevets

(11) **EP 4 325 718 A1**

(12) **EUROPÄISCHE PATENTANMELDUNG**

(43) Veröffentlichungstag:
**21.02.2024 Patentblatt 2024/08**

(21) Anmeldenummer: **22191001.1**

(22) Anmeldetag: **18.08.2022**

(51) Internationale Patentklassifikation (IPC):
***H02P 29/64*** *(2016.01)*

(52) Gemeinsame Patentklassifikation (CPC):
**H02P 29/64**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Drexel, Stefan**
**87745 Mörgen (DE)**
• **Jemiller, Johann**
**86868 Mittelneufnach (DE)**
• **Kellner, Sven Ludwig**
**91052 Erlangen (DE)**
• **Knecht, Karl-Heinz**
**91056 Erlangen (DE)**
• **Künzel, Stefan**
**91056 Erlangen (DE)**
• **Lampert, Markus**
**87772 Pfaffenhausen (DE)**
• **Nemeth-Csoka, Mihaly**
**91056 Erlangen (DE)**
• **Popp, Johannes**
**91052 Erlangen (DE)**
• **Rosenbaum, Lars**
**87755 Kirchhaslach Ot. Greimeltshofen (DE)**
• **Spindler, Carsten**
**91058 Erlangen (DE)**

(74) Vertreter: **Siemens Patent Attorneys**
**Postfach 22 16 34**
**80506 München (DE)**

(54) **ERMITTELN EINER WICKLUNGSTEMPERATUR EINER WICKLUNG EINES ELEKTROMOTORS**

(57) Die Erfindung betrifft ein Verfahren zum Ermitteln einer Wicklungstemperatur einer Wicklung (6) eines Elektromotors (5) und einen Stromrichter (1), der zur Steuerung eines Elektromotors (5) eingerichtet ist. Bei dem Verfahren wird wenigstens ein Messbetriebszustand des Elektromotors (5) für eine Messung eines elektrischen Wicklungswiderstands der Wicklung (6) festgelegt. In einem Messbetriebszustand des Elektromotors (5) wird der Wicklungswiderstand gemessen und die Wicklungstemperatur wird aus dem gemessenen Wicklungswiderstand berechnet. In einem von einem Messbetriebszustand verschiedenen Betriebszustand des Elektromotors (5) wird die Wicklungstemperatur mit einem thermischen Modell aus wenigstens einem Betriebsparameter des Elektromotors (5) berechnet.

FIG 2

EP 4 325 718 A1

**EP 4 325 718 A1**

**Beschreibung**

Die Erfindung betrifft ein Verfahren zum Ermitteln einer Wicklungstemperatur einer Wicklung eines Elektromotors. Ferner betrifft die Erfindung einen Stromrichter, der zur Steuerung eines Elektromotors eingerichtet ist. Der Elektromotor kann dabei im Allgemeinen eine als Synchronmotor oder Asynchronmotor ausgebildete rotierende elektrische Maschine, ein Linearmotor oder ein Reluktanzmotor sein. Ferner schließt der Begriff Elektromotor auch entsprechend ausgebildete Generatoren ein.

Viele Elektromotoren werden an einem Umrichter in Überlast betrieben. Dabei ist es wichtig, Wicklungen der Elektromotoren vor Überhitzung zu schützen. Überhitzungen können auch bei wassergekühlten oder fremdbelüfteten Elektromotoren durch Ausfall der Kühlung entstehen. Zum Schutz vor Überhitzungen wird häufig an der Wicklung eines Elektromotors ein Temperatursensor angeordnet, dessen Messwerte überwacht werden. Der Temperatursensor muss sicher elektrisch getrennt gegenüber der Wicklung sein. Dadurch ist die thermische Anbindung des Temperatursensors an die Wicklung nicht ideal und kann zu einer Messverzögerung von beispielsweise 10 Sekunden oder mehr führen. Ferner können einzelne Wicklungsstränge der Wicklung stärker erwärmt werden als die anderen, beispielsweise bei einer Belastung im Stillstand des Elektromotors. Falls der Temperatursensor nicht an dem am stärksten belasteten Wicklungsstrang angeordnet ist, ist der mit dem Temperatursensor implementierte Schutz unter Umständen nicht ausreichend. Außerdem kann der Temperatursensor oder die Zuleitung des Temperatursensors ausfallen. Ein Temperatursensor ist als sensibles Bauteil in einem ansonsten massiven Elektromotor daher nicht nur ausfallgefährdet, sondern er misst aufgrund von Verzögerungszeiten und einer nicht optimalen Einbaulage auch nicht besonders genau.

Der Erfindung liegt die Aufgabe zugrunde, ein verbessertes Verfahren und eine verbesserte Vorrichtung zum Ermitteln einer Wicklungstemperatur einer Wicklung eines Elektromotors anzugeben.

Die Aufgabe wird erfindungsgemäß durch ein Verfahren mit den Merkmalen des Anspruchs 1 und einen Stromrichter mit den Merkmalen des Anspruchs 15 gelöst.

Vorteilhafte Ausgestaltungen der Erfindung sind Gegenstand der Unteransprüche.

Bei dem erfindungsgemäßen Verfahren zum Ermitteln einer Wicklungstemperatur einer Wicklung eines Elektromotors wird wenigstens ein Messbetriebszustand des Elektromotors für eine Messung eines elektrischen Wicklungswiderstands der Wicklung festgelegt. In einem Messbetriebszustand des Elektromotors wird der Wicklungswiderstand gemessen und es wird die Wicklungstemperatur aus dem gemessenen Wicklungswiderstand berechnet. In einem von einem Messbetriebszustand verschiedenen Betriebszustand des Elektromotors wird die Wicklungstemperatur mit einem thermischen Modell aus wenigstens einem Betriebsparameter des Elektromotors berechnet.

Die Erfindung kombiniert also Messungen eines Wicklungswiderstands der Wicklung eines Elektromotors mit einem thermischen Modell zum Ermitteln einer Wicklungstemperatur der Wicklung. Dabei wird ausgenutzt, dass der Wicklungswiderstand temperaturabhängig ist und daher die Wicklungstemperatur aus dem Wicklungswiderstand berechnet werden kann. Allerdings ist eine Messung des Wicklungswiderstands nur in bestimmten Betriebszuständen des Elektromotors möglich. Insbesondere muss der Motorstrom für die Messung groß genug, damit an dem Wicklungswiderstand eine ausreichend hohe Spannung abfällt. Außerdem darf beispielsweise eine Geschwindigkeit eines Läufers des Elektromotors gegenüber einem Ständer des Elektromotors, im Fall einer rotierenden elektrischen Maschine also eine Winkelgeschwindigkeit des Läufers (Rotors) und im Fall eines Linearmotors eine translatorische Geschwindigkeit des Läufers, nicht zu groß sein, um die Messung durchführen zu können. Daher werden erfindungsgemäß Messbetriebszustände des Elektromotors festgelegt, in denen eine Messung des Wicklungswiderstands möglich ist und durchgeführt wird. In anderen Betriebszuständen des Elektromotors, das heißt in Betriebszuständen, in denen eine Messung des Wicklungswiderstands nicht möglich ist, wird dagegen ein thermisches Modell verwendet, um die Wicklungstemperatur aus wenigstens einem Betriebsparameter des Elektromotors zu berechnen.

Damit ermöglicht das erfindungsgemäße Verfahren eine Ermittlung der Wicklungstemperatur ohne einen Temperatursensor. Dadurch entfallen die oben genannten Nachteile des Einsatzes eines Temperatursensors, nämlich die Gefahr eines Ausfalls des Temperatursensors und Ungenauigkeiten und zeitliche Verzögerungen der Messungen mit dem Temperatursensor. Außerdem entfallen auch Kosten für den Temperatursensor sowie dessen Einbau und Verkabelung.

Insbesondere ermöglicht die Erfindung eine sehr genaue Ermittlung der Wicklungstemperatur in den Messbetriebszuständen durch Messungen des Wicklungswiderstands. Dies ist besonders vorteilhaft, da die Messbetriebszustände oft gerade kritische Betriebszustände sind, in denen einzelne Wicklungsstränge besonders stark belastet werden, beispielsweise Betriebszustände mit verschwindender oder sehr kleiner Geschwindigkeit des Läufers bei hohem Motorstrom. Die in den Messbetriebszuständen ermittelten Werte des Wicklungswiderstands können außerdem vorteilhaft als Anfangswerte für das thermische Modell und/oder zum Nachführen des thermischen Modells verwendet werden.

Bei einer Ausgestaltung der Erfindung wird im Fall eines mehrphasigen Elektromotors als Wicklungstemperatur in einem Betriebszustand des Elektromotors die Temperatur desjenigen Wicklungsstrangs der Wicklung des Elektromotors ermittelt, der in dem Betriebszustand die höchste Temperatur aufweist. Dabei wird die Temperatur desjenigen Wicklungsstrangs, der in dem Betriebszustand die höchste Temperatur aufweist, vorzugsweise mit dem thermischen

2

Modell ermittelt.

Die vorgenannte Ausgestaltung der Erfindung berücksichtigt, dass in der Regel eine Messung der Phasenwiderstände der Wicklungsstränge der einzelnen Phasen eines mehrphasigen Elektromotors nicht möglich ist. Vielmehr kann in der Regel als Wicklungswiderstand nur ein gemittelter Widerstand gemessen werden, der sich aus Anteilen der einzelnen Phasenwiderstände zusammensetzt, wobei diese Anteile von einer momentanen Stellung eines Stromraumzeigers des Stroms in der Wicklung abhängen. Es ist jedoch möglich, mit Hilfe des thermischen Modells und unter Berücksichtigung der jeweiligen Stellung des Stromraumzeigers aus dem gemittelten Widerstand mit guter Genauigkeit die Temperatur desjenigen Wicklungsstrangs der Wicklung des Elektromotors zu ermitteln, der in dem Betriebszustand die höchste Temperatur aufweist (siehe dazu die unten beschriebenen Ausführungsbeispiele). Diese Temperatur ist für den Schutz des Motors entscheidend. Daher wird erfindungsgemäß diese Temperatur als Wicklungstemperatur der Wicklung ermittelt. Die Berechnung dieser Temperatur wird vorzugsweise in dem thermischen Modell implementiert, so dass das thermische Modell insbesondere auch eingerichtet ist, aus den gemessenen Wicklungswiderständen jeweils die Temperatur desjenigen Wicklungsstrangs zu berechnen, der in dem jeweiligen Messbetriebszustand die höchste Temperatur aufweist.

Bei einer weiteren Ausgestaltung der Erfindung wird ein Motorstrom des Elektromotors als ein Betriebsparameter für die Berechnung der Wicklungstemperatur in einem von einem Messbetriebszustand verschiedenen Betriebszustand des Elektromotors verwendet. Alternativ oder zusätzlich wird beispielsweise eine Geschwindigkeit eines Läufers des Elektromotors relativ zu einem Ständer des Elektromotors als ein Betriebsparameter für die Berechnung der Wicklungstemperatur in einem von einem Messbetriebszustand verschiedenen Betriebszustand des Elektromotors verwendet.

Die vorgenannten Ausgestaltungen der Erfindung berücksichtigen, dass der Motorstrom und die Läufergeschwindigkeit des Elektromotors die für die Wicklungstemperatur wesentlichen Betriebsparameter des Elektromotors sind.

Bei einer weiteren Ausgestaltung der Erfindung wird der Wicklungswiderstand der Wicklung des Elektromotors gemessen, indem wenigstens ein in der Wicklung fließender elektrischer Strom und eine dazu korrespondierende elektrische Spannung erfasst werden und aus den Messwerten der Wicklungswiderstand der Wicklung des Elektromotors berechnet wird. Statt die Spannung zu messen, könnte prinzipiell zur Ermittlung des Wicklungswiderstands auch ein Spannungssollwert der Spannung verwendet werden. Dabei müssen jedoch Abweichungen des Spannungsistwerts vom Spannungssollwert mit ausreichender Genauigkeit berücksichtigt werden. Derartige Abweichungen entstehen beispielsweise aufgrund von Verriegelungszeiten von Halbleiterschaltern, mit denen die Spannung erzeugt wird.

Bei einer weiteren Ausgestaltung der Erfindung wird als ein Messbetriebszustand des Elektromotors ein Betriebszustand festgelegt, in dem ein Betrag eines Stromraumzeigers eines in der Wicklung fließenden elektrischen Stroms größer als ein vorgegebener Betragsschwellenwert ist. Diese Ausgestaltung der Erfindung berücksichtigt das oben bereits genannte Kriterium für eine Auswahl eines Messbetriebszustands des Elektromotors als eines Betriebszustands, in dem der Motorstrom für die Messung groß genug ist, damit an dem Wicklungswiderstand eine ausreichend hohe Spannung abfällt.

Bei einer weiteren Ausgestaltung der Erfindung wird als ein Messbetriebszustand des Elektromotors ein Betriebszustand festgelegt, in dem sich ein Läufer des Elektromotors relativ zu einem Ständer des Elektromotors nicht oder nur langsam, beispielsweise langsamer als ein vorgegebener Geschwindigkeitsschwellenwert, bewegt. Diese Ausgestaltung der Erfindung berücksichtigt das oben bereits genannte Kriterium für eine Auswahl eines Messbetriebszustands des Elektromotors als eines Betriebszustands mit einer verschwindenden oder geringen Läufergeschwindigkeit. Zusätzlich wird der Messbetriebszustand beispielsweise dadurch festgelegt, dass ein Betrag eines Stromraumzeigers eines in der Wicklung fließenden elektrischen Stroms sich am Ende eines Messzeitraums nicht wesentlich von dem Betrag am Anfang des Messzeitraums unterscheidet, beispielsweise um weniger als ein vorgegebener Abweichungsschwellenwert, und der Wicklungswiderstand wird als ein Mittelwert über mehrere während des Messzeitraums durchgeführte Messungen, beispielsweise über etwa 200 Messungen, ermittelt. Durch eine Ermittlung des Wicklungswiderstands als ein Mittelwert über mehrere Messungen unter den genannten Bedingungen werden der Messfehler reduziert und die Genauigkeit der Messung erhöht.

Bei einer weiteren Ausgestaltung der Erfindung wird als ein Messbetriebszustand ein Betriebszustand festgelegt, während dessen ein in der Wicklung fließender elektrischer Strom mit einer Modulationsfrequenz moduliert wird, und der Wicklungswiderstand wird aus den Modulationen des elektrischen Stroms und einer zugehörigen an der Wicklung anliegenden elektrischen Spannung berechnet. Im Fall eines dreiphasigen Elektromotors wird dabei beispielsweise ein Strom entlang einer d-Achse und/oder ein Strom entlang einer q-Achse eines d/q-Koordinatensystems mit der Modulationsfrequenz moduliert.

Die vorgenannte Ausgestaltung der Erfindung ist eine Messmethode zur Messung des Wicklungswiderstands, die alternativ oder zusätzlich zu der oben beschriebenen Messmethode (Messungen bei kleinen Läufergeschwindigkeiten unter den oben genannten Voraussetzungen) verwendet werden kann. Der Wicklungswiderstand und die Wicklungstemperatur werden dabei aus dem modulierten Strom und einer zugehörigen modulierten Spannung ermittelt. Diese Messmethode hat den Vorteil, dass sie auch im Betrieb des Elektromotors bei höheren Läufergeschwindigkeiten verwendet werden kann. Allerdings erfordert sie eine Modulation des Stroms in der Wicklung, die den Betrieb des Elektromotors nicht beeinträchtigt und trotzdem die Messung des Wicklungswiderstands ermöglicht. Auch bei dieser Messmethode wird vorzugsweise das thermische Modell verwendet, um aus den Messwerten die Temperatur desjenigen Wicklungsstrangs der Wicklung zu ermitteln, der die höchste Temperatur aufweist.

Bei einer weiteren Ausgestaltung der Erfindung wird die Wicklungstemperatur für eine Wicklung eines Ständers des Elektromotors ermittelt.

Bei einer weiteren Ausgestaltung der Erfindung wird von dem thermischen Modell bei der Berechnung der Wicklungstemperatur in einem von einem Messbetriebszustand verschiedenen Betriebszustand wenigstens eine in einem Messbetriebszustand des Elektromotors ermittelte Wicklungstemperatur als ein Anfangswert verwendet. Diese Ausgestaltung der Erfindung berücksichtigt, dass das thermische Modell die Wicklungstemperatur in der Regel iterativ, ausgehend von Anfangswerten, berechnet. Da eine in einem Messbetriebszustand des Elektromotors ermittelte Wicklungstemperatur ein Messwert ist beziehungsweise aus Messwerten berechnet wird, eignet sie sich als realistischer Anfangswert für die Berechnung der Wicklungstemperatur mit dem thermischen Modell.

Bei einer weiteren Ausgestaltung der Erfindung wird von dem thermischen Modell bei der Berechnung der Wicklungstemperatur in einem von einem Messbetriebszustand verschiedenen Betriebszustand wenigstens eine in einem Messbetriebszustand des Elektromotors ermittelte Wicklungstemperatur zum Nachführen des thermischen Modells verwendet. Diese Ausgestaltung der Erfindung ermöglicht ein Nachführen des thermischen Modells, beispielsweise mittels eines so genannten Beobachters, mit in Messbetriebszuständen ermittelten realistischen Werten der Wicklungstemperatur und verbessert somit die Genauigkeit des thermischen Modells.

Ein erfindungsgemäßer Stromrichter ist zur Steuerung eines Elektromotors eingerichtet und umfasst

- eine Strommessvorrichtung, die zum Messen wenigstens eines elektrischen Stroms in einer Wicklung des Elektromotors eingerichtet ist,
- eine Spannungsmessvorrichtung, die zum Messen wenigstens einer zu einem gemessenen Strom korrespondierenden elektrischen Spannung eingerichtet ist, und
- eine Recheneinheit, die eingerichtet ist, aus in einem festgelegten Messbetriebszustand des Elektromotors von der Strommessvorrichtung und der Spannungsmessvorrichtung erfassten Messwerten eine Wicklungstemperatur der Wicklung des Elektromotors zu berechnen und in einem von einem Messbetriebszustand verschiedenen Betriebszustand des Elektromotors die Wicklungstemperatur mit einem thermischen Modell aus wenigstens einem Betriebsparameter des Elektromotors zu berechnen.

Ein erfindungsgemäßer Stromrichter ermöglicht die Durchführung des erfindungsgemäßen Verfahrens. Daher entsprechen die Vorteile eines erfindungsgemäßen Stromrichters den oben genannten Vorteilen des erfindungsgemäßen Verfahrens.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:

FIG 1    ein Blockdiagramm eines Ausführungsbeispiels eines Stromrichters zur Steuerung eines Elektromotors,

FIG 2    schematisch eine Wicklung eines Elektromotors,

FIG 3    ein Ablaufdiagramm eines Ausführungsbeispiels des erfindungsgemäßen Verfahrens,

FIG 4    ein PT1-Glied für die Berechnung einer Wicklungstemperatur eines Elektromotors.

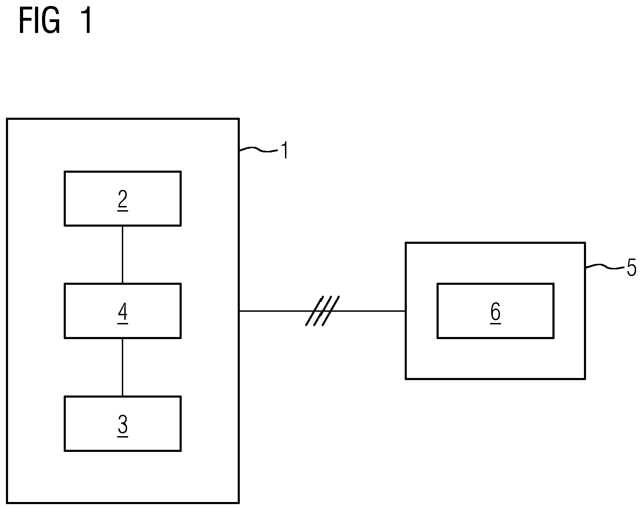

Figur 1 (FIG 1) zeigt ein Blockdiagramm eines Ausführungsbeispiels eines Stromrichters 1 zur Steuerung eines Elektromotors 5. Der Elektromotor 5 ist bei diesem Ausführungsbeispiel dreiphasig mit einem Ständer und einem Läufer ausgebildet. Der Ständer weist eine Wicklung 6 auf, für die wie nachfolgend beschrieben in verschiedenen Betriebszuständen des Elektromotors 5 Wicklungstemperaturen ermittelt werden.

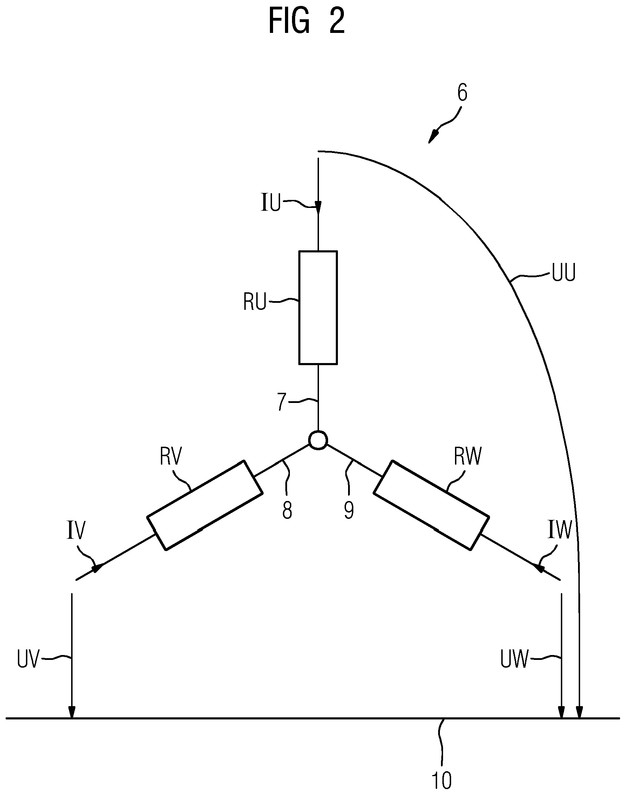

Figur 2 (FIG 2) zeigt schematisch die Wicklung 6 des Ständers des Elektromotors 5. Die Wicklung 6 weist für jede Phase des Elektromotors 5 einen Wicklungsstrang 7, 8, 9 auf. Die Wicklungsstränge 7, 8, 9 sind miteinander in einer Sternschaltung elektrisch verschaltet und beispielsweise jeweils durch Nuten eines Blechpakets des Ständers geführt.

Ein Wicklungsstrang 7 einer ersten Phase, die als U-Phase bezeichnet wird, weist einen elektrischen Phasenwiderstand RU auf. Ein Wicklungsstrang 8 einer zweiten Phase, die als V-Phase bezeichnet wird, weist einen elektrischen Phasenwiderstand RV auf. Ein Wicklungsstrang 9 der dritten Phase, die als W-Phase bezeichnet wird, weist einen elektrischen Phasenwiderstand RW auf. Die Phasenwiderstände RU, RW, RV sind temperaturabhängig, das heißt hängen von einer Temperatur des jeweiligen Wicklungsstrangs 7, 8, 9 ab.

Im Betrieb des Elektromotors 5 fließt in dem Wicklungsstrang 7 der U-Phase ein elektrischer Phasenstrom IU, in dem Wicklungsstrang 8 der V-Phase fließt ein elektrischer Phasenstrom IV und in dem Wicklungsstrang 9 der W-Phase fließt ein elektrischer Phasenstrom IW.

Der Stromrichter 1 weist beispielsweise in bekannter Weise für jede Phase des Elektromotors 5 eine (hier nicht dargestellte) Halbbrücke mit zwei Halbleiterschaltern auf, die pulsweitenmoduliert angesteuert werden. Ferner umfasst der Stromrichter 1 eine Strommessvorrichtung 2, die zum Messen jedes Phasenstroms IU, IV, IW eingerichtet ist, sowie eine Spannungsmessvorrichtung 3. Die Spannungsmessvorrichtung 3 ist eingerichtet, für jeden Wicklungsstrang 7, 8, 9 eine Phasenspannung UU, UV, UW zwischen dem jeweiligen Wicklungsstrang 7, 8, 9 und einer elektrischen Referenzleitung 10 zu messen, die auf einem elektrischen Bezugspotential liegt. Das Bezugspotential ist beispielsweise ein Potential einer elektrischen Gleichspannung eines elektrischen Zwischenkreises des Stromrichters 1, aus dem dessen Halbleiterschalter mit elektrischer Spannung versorgt werden.

Der Stromrichter 1 weist ferner eine Recheneinheit 4 auf, die eingerichtet ist, die Wicklungstemperatur der Wicklung 6 des Elektromotors 5 gemäß dem unten beschriebenen Verfahren zu ermitteln. Die Recheneinheit 4 kann insbesondere in eine Steuereinheit des Stromrichters 1 integriert sein, die die Halbleiterschalter des Stromrichters 1 ansteuert. Beispielsweise kann die Recheneinheit 4 als ein in der Steuereinheit implementiertes und von der Steuereinheit ausführbares Computerprogramm realisiert sein, das zur Ermittlung der Wicklungstemperatur der Wicklung 6 des Elektromotors 5 eingerichtet ist.

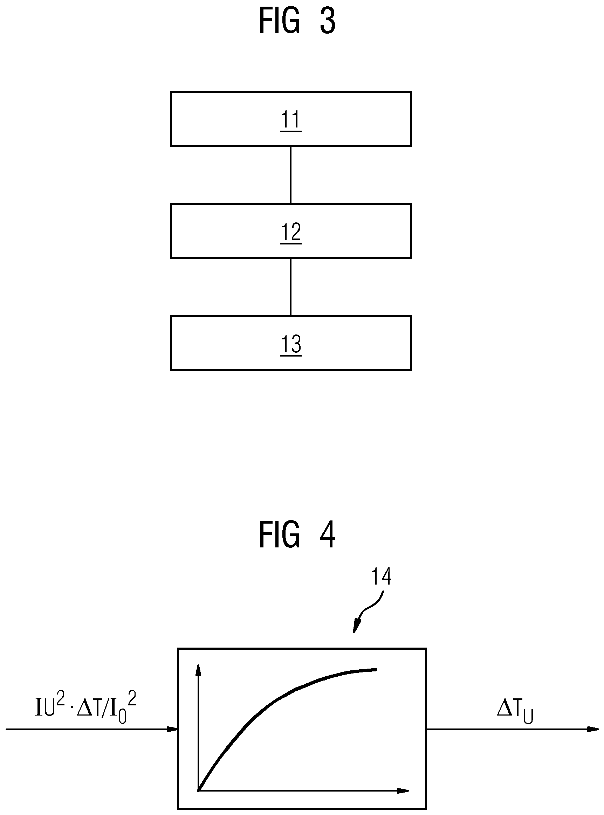

Figur 3 (FIG 3) zeigt ein Ablaufdiagramm eines Ausführungsbeispiels des erfindungsgemäßen Verfahrens mit Verfahrensschritten 11, 12, 13 zum Ermitteln der Wicklungstemperatur der Wicklung 6.

In einem ersten Verfahrensschritt 11 wird wenigstens ein Messbetriebszustand des Elektromotors 5 für eine Messung des Wicklungswiderstands während eines Messzeitraums festgelegt. Als ein Messbetriebszustand wird beispielsweise ein Betriebszustand festgelegt, in dem sich der Läufer des Elektromotors 5 während des Messzeitraums relativ zu dem Ständer des Elektromotors 5 nicht oder nur langsam, beispielsweise langsamer als ein vorgegebener Geschwindigkeitsschwellenwert, bewegt, und ein Betrag eines Stromraumzeigers, der aus den Phasenströmen IU, IV, IW gebildet wird, sich am Ende des Messzeitraums nicht wesentlich von dem Betrag am Anfang des Messzeitraums unterscheidet, beispielsweise um weniger als ein vorgegebener Abweichungsschwellenwert.

In einem zweiten Verfahrensschritt 12 wird in einem Messbetriebszustand des Elektromotors 5 der Wicklungswiderstand gemessen und die Wicklungstemperatur wird aus dem gemessenen Wicklungswiderstand berechnet.

Zur Messung des Wicklungswiderstands werden die Phasenströme IU, IV, IW und Phasenspannungen UU, UV, UW beispielsweise in dem Messzeitraum mehrfach gemessen, beispielsweise jeweils etwa 200 mal, und aus den Messwerten wird für jeden Phasenstrom IU, IV, IW und jede Phasenspannung UU, UV, UW ein Mittelwert gebildet. Aus den Mittelwerten der Phasenströme IU, IV, IW wird beispielsweise ein Stromraumzeiger gebildet, der in einem läuferfesten d/q-Koordinatensystem eine Komponente id entlang einer d-Achse und eine Komponente iq entlang einer q-Achse des Koordinatensystems aufweist. Ferner wird aus den Mittelwerten der Phasenspannungen UU, UV, UW ein Spannungsraumzeiger gebildet, der in dem d/q-Koordinatensystem eine Komponente ud entlang der d-Achse und eine Komponente uq entlang der q-Achse aufweist. Aus dem Stromraumzeiger und dem Spannungsraumzeiger wird der Wicklungswiderstand als ein Raumzeigerwiderstand $R_{RZS}$ berechnet, beispielsweise gemäß

$$R_{RZS} = [ud \cdot iq + (uq-uL) \cdot iq)] / (id^2 + iq^2),$$

wobei uL eine von dem Läufer in q-Richtung induzierte Spannung bezeichnet, die von einer Läufergeschwindigkeit des Läufers abhängt und beispielsweise als proportional zu der Läufergeschwindigkeit behandelt wird.

Als Wicklungstemperatur wird mit einem thermischen Modell des Elektromotors 5 die Temperatur desjenigen Wicklungsstrangs 7, 8, 9 ermittelt, der in dem Messbetriebszustand die höchste Temperatur aufweist. Beispielsweise wird die Wicklungstemperatur aus dem Wicklungswiderstand gemäß

$$T = T_0 + (R_{RZS}/R_0 - 1) \cdot (1/k) \cdot K$$

mit folgenden Bezeichnungen berechnet:

$T_0$: Referenztemperatur,
Ro: Wert des Raumzeigerwiderstands $R_{RZS}$ bei der Referenztemperatur,
k: von dem Material der Wicklung abhängiger Koeffizient für die Temperaturabhängigkeit des Wicklungswiderstands,
K: Korrekturfaktor.

Der Korrekturfaktor K dient dazu, aus dem Raumzeigerwiderstand $R_{RZS}$ als Wicklungstemperatur T die Temperatur desjenigen Wicklungsstrangs 7, 8, 9 zu berechnen, der in dem Messbetriebszustand die höchste Temperatur aufweist. Beispielsweise wird der Korrekturfaktor K gemäß

$$K=(3/2) \cdot I^2 \cdot \max_i\{PT1(I_i^2)\}/\text{sum}_i\{PT1(I_i^2) \cdot I_i^2\}$$

mit folgenden Bezeichnungen berechnet:

I: Betrag des Stromraumzeigers,
i: Index, der über die drei Phasen U, V, W läuft,
$PT1(I_i^2)$: Ausgangswert eines PT1-Gliedes 14 für die Phase i (siehe Figur 4 und deren Beschreibung),
$\max_i\{PT1(I_i^2)\}$: Maximum von $PT1(IU^2)$, $PT1(IV^2)$ und $PT1(IW^2)$, $\text{sum}_i\{PT1(I_i^2) \cdot I_i^2\}=PT1(IU^2) \cdot IU^2+PT1(IV^2) \cdot IV^2+PT1(IW^2) \cdot IW^2$.

Der Korrekturfaktor K berücksichtigt, dass in der Regel die Messungen der Phasenströme IU, IV, IW und Phasenspannungen UU, UV, UW nicht die Ermittlung der Phasenwiderstände RU, RV, RW der Wicklungssträge der einzelnen Phasen ermöglichen, weil sich aus den Messungen der Phasenspannungen UU, UV, UW, jeweils gemessen gegenüber dem Bezugspotential der Referenzleitung 10, nicht die Spannungen der Phasenwicklungen 7, 8, 9 gegenüber dem Sternpunkt der Sternpunktschaltung der Phasenwicklungen 7, 8, 9 (siehe Figur 2) ermitteln lassen. Der Mittelwert der Phasenspannungen UU, UV, UW, ergibt nur dann die Sternpunktspannung, wenn alle Phasenwiderstände RU, RV, RW gleich groß sind, was jedoch hier, aufgrund der unterschiedlichen Erwärmung der einzelnen Phasenwicklungen 7, 8, 9, gerade nicht vorausgesetzt werden kann.

Figur 4 (FIG 4) zeigt schematisch das PT1-Glied 14 für die U-Phase der Wicklung 6. Eingangswert für das PT1-Glied 14 ist im Wesentlichen das Quadrat $IU^2$ des Phasenstroms IU, multipliziert mit dem Verhältnis $\Delta T/I_0^2$, wobei $\Delta T$ eine Temperaturerhöhung $\Delta T$ des Wicklungsstrangs 7 der U-Phase bei einem Referenzstrom $I_0$, beispielsweise bei einem Stillstandsstrom des Elektromotors 5, ist. Ausgangswert $PT1(IU^2)=\Delta T_U$ des PT1-Glieds 14 ist eine Temperaturerhöhung $\Delta T_U$ des Wicklungsstrangs 7 der U-Phase in Abhängigkeit von dem Eingangswert gegenüber der Referenztemperatur. Die PT1-Glieder für die Phasen V und W entsprechen dem PT1-Glied für die U-Phase, wobei die Eingangswerte dieser PT1-Glieder die Quadrate $IV^2$ beziehungsweise $IW^2$ anstelle von $IU^2$ enthalten.

Die anhand der Figuren 2 und 3 beschriebene Ermittlung der Wicklungstemperatur kann in verschiedener Weise geändert, insbesondere verfeinert werden. Beispielsweise kann die Berechnung der Wicklungstemperatur auch den Einfluss eines Blechpakets des Ständers und/oder des Läufers des Elektromotors 5 berücksichtigen.

In einem dritten Verfahrensschritt 13 wird in einem von einem Messbetriebszustand verschiedenen Betriebszustand des Elektromotors 5 die Wicklungstemperatur mit dem thermischen Modell aus wenigstens einem Betriebsparameter des Elektromotors 5 berechnet. Als ein Betriebsparameter für die Berechnung der Wicklungstemperatur wird dabei beispielsweise ein Motorstrom des Elektromotors 5 verwendet. Alternativ oder zusätzlich wird beispielsweise die Geschwindigkeit des Läufers des Elektromotors 5 relativ zu dem Ständer des Elektromotors 5 als ein Betriebsparameter für die Berechnung der Wicklungstemperatur verwendet. Beispielsweise wird von dem thermischen Modell bei der Berechnung der Wicklungstemperatur eine in einem Messbetriebszustand des Elektromotors 5 ermittelte Wicklungstemperatur als ein Anfangswert verwendet. Ferner können Wicklungstemperaturen, die jeweils in einem Messbetriebszustand des Elektromotors 5 ermittelt werden, zum Nachführen des thermischen Modells verwendet werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zum Ermitteln einer Wicklungstemperatur einer Wicklung (6) eines Elektromotors (5), wobei

   - wenigstens ein Messbetriebszustand des Elektromotors (5) für eine Messung eines elektrischen Wicklungswiderstands der Wicklung (6) festgelegt wird,
   - in einem Messbetriebszustand des Elektromotors (5) der Wicklungswiderstand gemessen wird und die Wicklungstemperatur aus dem gemessenen Wicklungswiderstand berechnet wird und
   - in einem von einem Messbetriebszustand verschiedenen Betriebszustand des Elektromotors (5) die Wicklungstemperatur mit einem thermischen Modell aus wenigstens einem Betriebsparameter des Elektromotors (5) berechnet wird.

2. Verfahren nach Anspruch 1, wobei im Fall eines mehrphasigen Elektromotors (5) als Wicklungstemperatur in einem Betriebszustand des Elektromotors (5) die Temperatur desjenigen Wicklungsstrangs (7, 8, 9) der Wicklung (6) des Elektromotors (5), der in dem Betriebszustand die höchste Temperatur aufweist, ermittelt wird.

3. Verfahren nach Anspruch 2, wobei die Temperatur desjenigen Wicklungsstrangs (7, 8, 9), der in dem Betriebszustand die höchste Temperatur aufweist, mit dem thermischen Modell ermittelt wird.

4. Verfahren nach einem der vorhergehenden Ansprüche, wobei ein Motorstrom des Elektromotors (5) als ein Betriebsparameter für die Berechnung der Wicklungstemperatur in einem von einem Messbetriebszustand verschiedenen Betriebszustand des Elektromotors (5) verwendet wird.

5. Verfahren nach einem der vorhergehenden Ansprüche, wobei eine Geschwindigkeit eines Läufers des Elektromotors (5) relativ zu einem Ständer des Elektromotors (5) als ein Betriebsparameter für die Berechnung der Wicklungstemperatur in einem von einem Messbetriebszustand verschiedenen Betriebszustand des Elektromotors (5) verwendet wird.

6. Verfahren nach einem der vorhergehenden Ansprüche, wobei der Wicklungswiderstand der Wicklung (6) des Elektromotors (5) gemessen wird, indem wenigstens ein in der Wicklung (6) fließender elektrischer Strom (IU, IV, IW) und eine dazu korrespondierende elektrische Spannung (UU, UV, UW) erfasst werden und aus den Messwerten der Wicklungswiderstand der Wicklung (6) des Elektromotors (5) berechnet wird.

7. Verfahren nach einem der vorhergehenden Ansprüche, wobei als ein Messbetriebszustand des Elektromotors (5) ein Betriebszustand festgelegt wird, in dem ein Betrag eines Stromraumzeigers eines in der Wicklung (6) fließenden elektrischen Stroms größer als ein vorgegebener Betragsschwellenwert ist.

8. Verfahren nach einem der vorhergehenden Ansprüche, wobei als ein Messbetriebszustand des Elektromotors (5) ein Betriebszustand festgelegt wird, in dem sich ein Läufer des Elektromotors (5) relativ zu einem Ständer des Elektromotors (5) nicht oder nur langsam, beispielsweise langsamer als ein vorgegebener Geschwindigkeitsschwellenwert, bewegt.

9. Verfahren nach Anspruch 7 oder 8, wobei der Messbetriebszustand zusätzlich dadurch festgelegt wird, dass ein Betrag eines Stromraumzeigers eines in der Wicklung (6) fließenden elektrischen Stroms sich am Ende eines Messzeitraums nicht wesentlich von dem Betrag am Anfang des Messzeitraums unterscheidet, beispielsweise um weniger als ein vorgegebener Abweichungsschwellenwert, und der Wicklungswiderstand als ein Mittelwert über mehrere während des Messzeitraums durchgeführte Messungen ermittelt wird.

10. Verfahren nach einem der vorhergehenden Ansprüche, wobei als ein Messbetriebszustand ein Betriebszustand festgelegt wird, während dessen ein in der Wicklung (6) fließender elektrischer Strom mit einer Modulationsfrequenz moduliert wird, und der Wicklungswiderstand aus den Modulationen des elektrischen Stroms und einer zugehörigen an der Wicklung (6) anliegenden elektrischen Spannung berechnet wird.

11. Verfahren nach Anspruch 10, wobei im Fall eines dreiphasigen Elektromotors (5) ein Strom entlang einer d-Achse und/oder ein Strom entlang einer q-Achse eines d/q-Koordinatensystems mit der Modulationsfrequenz moduliert wird.

12. Verfahren nach einem der vorhergehenden Ansprüche, wobei die Wicklungstemperatur für eine Wicklung (6) eines Ständers des Elektromotors (5) ermittelt wird.

13. Verfahren nach einem der vorhergehenden Ansprüche, wobei von dem thermischen Modell bei der Berechnung der Wicklungstemperatur in einem von einem Messbetriebszustand verschiedenen Betriebszustand wenigstens eine in einem Messbetriebszustand des Elektromotors (5) ermittelte Wicklungstemperatur als ein Anfangswert verwendet wird.

14. Verfahren nach einem der vorhergehenden Ansprüche, wobei von dem thermischen Modell bei der Berechnung der Wicklungstemperatur in einem von einem Messbetriebszustand verschiedenen Betriebszustand wenigstens eine in einem Messbetriebszustand des Elektromotors (5) ermittelte Wicklungstemperatur zum Nachführen des thermischen Modells verwendet wird.

15. Stromrichter (1), der zur Steuerung eines Elektromotors (5) eingerichtet ist, der Stromrichter (1) umfassend

- eine Strommessvorrichtung (2), die zum Messen wenigstens eines elektrischen Stroms (IU, IV, IW) in einer Wicklung (6) des Elektromotors (5) eingerichtet ist,
- eine Spannungsmessvorrichtung (3), die zum Messen wenigstens einer zu einem gemessenen Strom (IU, IV, IW) korrespondierenden elektrischen Spannung (UU, UV, UW) eingerichtet ist, und
- eine Recheneinheit (4), die eingerichtet ist, in einem festgelegten Messbetriebszustand des Elektromotors (5) aus von der Strommessvorrichtung (2) und der Spannungsmessvorrichtung (3) erfassten Messwerten eine Wicklungstemperatur der Wicklung (6) des Elektromotors (5) zu berechnen und in einem von einem Messbetriebszustand verschiedenen Betriebszustand des Elektromotors (5) die Wicklungstemperatur mit einem thermischen Modell aus wenigstens einem Betriebsparameter des Elektromotors (5) zu berechnen.

FIG 1

# FIG 2

# FIG 3

# FIG 4

$$IU^2 \cdot \Delta T/I_0^2 \qquad\qquad \Delta T_U$$

Europäisches
Patentamt

European
Patent Office

Office européen
des brevets

## EUROPÄISCHER RECHERCHENBERICHT

Nummer der Anmeldung

EP 22 19 1001

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2014 005706 A1 (DIEHL AKO STIFTUNG GMBH & CO [DE]) 22. Oktober 2015 (2015-10-22) * Absatz [0046] * * Absatz [0041] * * Absatz [0012] * * Absatz [0013] * * Absatz [0040] * ----- | 1,4,6, 13-15 | INV. H02P29/64 |
| X | US 2021/305929 A1 (PRAMOD PRERIT [US] ET AL) 30. September 2021 (2021-09-30) * Absatz [0060] * * Absatz [0061] * * Absatz [0031] * * Absatz [0047] * * Absatz [0048] * * Absatz [0024] * * Absatz [0056] * ----- | 1-3,5, 7-12,15 | |
| X | CHING-YIN LEE: "Effects of Unbalanced Voltage on the Operation Performance of a Three-Phase Induction Motor", IEEE TRANSACTIONS ON ENERGY CONVERSION, IEEE SERVICE CENTER, PISCATAWAY, NJ, US, Bd. 14, Nr. 2, Juni 1999 (1999-06), Seiten 202-208, XP011084415, ISSN: 0885-8969, DOI: 10.1109/60.766984 * Seite 206, rechte Spalte, Absatz erster * ----- | 1,15 | RECHERCHIERTE SACHGEBIETE (IPC) H02P |

Der vorliegende Recherchenbericht wurde für alle Patentansprüche erstellt

| Recherchenort | Abschlußdatum der Recherche | Prüfer |
|---|---|---|
| München | 11. Januar 2023 | Fligl, Stanislav |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

**EP 22 19 1001**

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

**11-01-2023**

| Im Recherchenbericht angeführtes Patentdokument | Datum der Veröffentlichung | Mitglied(er) der Patentfamilie | Datum der Veröffentlichung |
|---|---|---|---|
| DE 102014005706 A1 | 22-10-2015 | CN 105048408 A<br>DE 102014005706 A1 | 11-11-2015<br>22-10-2015 |
| US 2021305929 A1 | 30-09-2021 | CN 113466556 A<br>DE 102021107106 A1<br>US 2021305929 A1 | 01-10-2021<br>30-09-2021<br>30-09-2021 |

EPO FORM P0461

Für nähere Einzelheiten zu diesem Anhang : siehe Amtsblatt des Europäischen Patentamts, Nr.12/82